# EUROPÄISCHE PATENTANMELDUNG

(11) **EP 0 641 156 A1**
(43) Veröffentlichungstag der Anmeldung: **01.03.1995**
(21) Anmeldenummer: 94112098.2
(22) Anmeldetag: 03.08.1994
(51) Int. Cl.: H05K 13/00

(54) **Halterung für plattenförmige Gegenstände, insbesondere Leiterplatten sowie Entnahme- und Beschickungseinrichtung für diese Halterung**

(30) Priorität: 24.08.1993 DE 4328359
(71) Anmelder: Gebr. Schmid GmbH & Co., D-72250 Freudenstadt (DE)
(72) Erfinder: Schmid, Dieter C., D-72250 Freudenstadt-Dietersweiler (DE)
(74) Vertreter: Patentanwälte Ruff, Beier, Schöndorf und Mütschele

(57) **Zusammenfassung**

Bei einer Halterung für plattenförmige Gegenstände, insbesondere Leiterplatten und Formätzteile ist eine Aufnahme für mindestens einen plattenförmigen Gegenstand vorgesehen und die plattenförmigen Gegenstände sind in der Halterung hintereinander bzw. nebeneinander hängend angeordnet. Dabei sind die plattenförmigen Gegenstände vorzugsweise mit gegenseitigem Abstand zueinander fixiert. Eine Entnahme- und/oder Beschickungseinrichtung für plattenförmige Gegenstände weist eine solche Halterung auf. Dabei ist diese Halterung vorzugsweise oberhalb der Transport- oder Behandlungsvorrichtung angeordnet, von der die plattenförmigen Gegenstände entnommen oder in die sie eingebracht werden.

## Beschreibung

Die Erfindung betrifft eine Halterung für plattenförmige Gegenstände, insbesondere Leiterplatten und Formätzteile, mit mindestens einer Aufnahme für mindestens einen plattenförmigen Gegenstand. Außerdem betrifft die Erfindung eine Einrichtung zur Entnahme und/oder zum Beschicken von plattenförmigen Gegenständen, insbesondere Leiterplatten und Formätzteilen, von einer bzw. auf eine Transport- und/oder Behandlungsvorrichtung, vorzugsweise Transport- und/oder Behandlungsstrecke.

Der Hintergrund der Erfindung ist, daß beispielsweise Leiterplatten immer dünner und flexibler ausgebildet sind und daß ihre Oberfläche zunehmend empfindlicher wird. So besitzen Lackschichten auf Leiterplatten beispielsweise Dicken zwischen 3 und 5 µm und Metallaufbauten auf Leiterplatten können Höhen von weniger als 1 µm aufweisen. Damit lassen sich solche Leiterplatten praktisch nicht mehr aufeinanderliegend transportieren und auch eine Lagerung oder Transport in Steckbrettern oder in schrägen Kassetten ist nur unter Schwierigkeiten möglich. Demzufolge sind auch übliche Stapeleinrichtungen für solche Steckbretter oder Kassetten nicht mehr einsetzbar.

Da aufgrund der reduzierten Dicke und der Flexibilität die Leiterplatten zunehmend einzeln und liegend transportiert werden müssen, entsteht aber gerade ein Bedarf nach dauernder oder vorübergehender Lagerung der plattenförmigen Gegenstände, um beispielsweise einen Stau bei Eintritt oder Austritt in Behandlungsstationen bei der Leiterplattenherstellung zu verhindern.

Die Erfindung stellt sich die Aufgabe, eine Halterung für plattenförmige Gegenstände zur Verfügung zu stellen, die den oben geschilderten Anforderungen gerecht wird. Dabei sollen die geschilderten Nachteile bekannter Halterungen vermieden und trotzdem eine einfache und zweckmäßige Lagerung ermöglicht werden. Die plattenförmigen Gegenstände sollen schnell und zuverlässig in die Halterung eingebracht werden können und auch die Entnahme der plattenförmigen Gegenstände aus der Halterung soll ohne großen Aufwand erfolgen können. Weiter stellt sich die Erfindung die Aufgabe, eine Belade-/Entladeeinrichtung für solche Halterungen bereit zu stellen.

Diese Aufgabe wird gelöst durch eine Halterung mit den Merkmalen des Anspruchs 1 und durch eine Entnahme- und/oder Beschickungseinrichtung mit den Merkmalen des Anspruchs 11. Bevorzugte Ausführungsformen dieser Gegenstände sind in den Unteransprüchen 2 bis 10 bzw. 12 bis 21 beschrieben.

Die erfindungsgemäße Halterung mit mindestens einer Aufnahme für mindestens einen plattenförmigen Gegenstand ist dadurch gekennzeichnet, daß die plattenförmigen Gegenstände in der Halterung hintereinander hängend anordenbar sind. Vorzugsweise sind die plattenförmigen Gegenstände dabei mit gegenseitigem Abstand zueinander gehalten, so daß ein direkter Kontakt zwischen den einzelnen plattenförmigen Gegenständen vermieden wird. Der Ausdruck "hintereinander" soll gemäß der Erfindung sämtliche Fälle umfassen, in denen mindestens zwei plattenförmige Gegenstände aufeinanderfolgend in der Halterung hängend angeordnet sind. Üblicherweise sind die plattenförmigen Gegenstände bei der Erfindung so angeordnet, daß sie mit ihrer Ober- bzw. Unterseite aneinandergrenzen, also "hintereinander" angeordnet sind. Auf diese Weise können mehr Platten in der Halterung untergebracht werden als bei einer Anordnung "nebeneinander".

Durch die hängende Lagerung der plattenförmigen Gegenstände in der Halterung lassen sich auch dünne, flexible oder anderweitig empfindliche plattenförmige Gegenstände, wie beispielsweise die oben beschriebenen Leiterplatten auf einfache Weise schonend lagern. Der überwiegende Teil des Gegenstandes hängt frei und es wirken keine gegebenenfalls schädlichen Kräfte auf den Gegenstand ein, wie dies beispielsweise bei einer Lagerung in Steckbrettern bei flexiblem Aufbau und möglicherweise ungünstiger Lastverteilung der plattenförmigen Gegenstände der Fall sein kann. Bei der Erfindung kann das Einbringen der plattenförmigen Gegenstände in die Halterung und das Entnehmen aus der Halterung in einfacher Weise so erfolgen, daß der plattenförmige Gegenstand, der als erster in der Halterung "abgehängt" wird, auch wieder als erster aus der Halterung entnommen werden kann. Ein Drehen oder Wenden des plattenförmigen Gegenstandes, bei dem empfindliche Gegenstände unter Umständen beschädigt werden könnten, kann unterbleiben. Dadurch wird bei der Erfindung sowohl der Effekt einer schonenden Lagerung als auch der Effekt eines rationellen Beladens und Entladens der Halterung erreicht.

In Weiterbildung weist die erfindungsgemäße Halterung mindestens eine Führung für die Aufnahmen auf. Entlang dieser Führung können die Aufnahmen einfach nur befestigt sein. Es ist jedoch auch bevorzugt, wenn die Aufnahmen entlang der Führung verschiebbar sind. Dadurch ist es möglich, den Abstand der Aufnahmen zueinander zu variieren. Bei der Erfindung ist prinzipiell jede Art der Führung für die Aufnahmen möglich, bevorzugt sind beispielsweise Führungsbänder, Führungsschienen oder Führungsstangen. Dabei können diese Bänder, Schienen oder Stangen beispielsweise durch die Aufnahmen hindurchgeführt und die Aufnahmen so auf diesen Führungen aufgereiht sein.

Bevorzugt sind die Aufnahmen entlang der Führung in sich wiederholenden Abständen angeordnet. Dabei kann es sich vorzugsweise um regelmäßige Abstände handeln. Durch die Wahl sich wiederholender Abstände wird beispielsweise eine automatische Beladung oder Entladung der Halterung ermöglicht, indem entweder eine Belade-/Entladeeinrichtung in sich wiederholenden, vorzugsweise regelmäßigen Abständen weitergefahren wird, oder die Halterung selbst relativ zu dieser Einrichtung bewegt wird. Dies ist besonders bei einem taktweisen Beladen und Entladen von Vorteil.

Bei bevorzugten Ausführungsformen sind die Aufnahmen entlang der Führung reibschlüssig angeordnet. Dies bedeutet, daß sich die Aufnahme aufgrund von Reibungskräften normalerweise an einer bestimmten Stelle an der Führung befindet. Insbesondere ist jedoch die Aufnahme dann entlang der Führung verschiebbar, wenn eine Kraft aufgebracht wird, die die Reibungskräfte überwindet. So kann beispielsweise die Aufnahme zusammen mit der Führung bewegt werden, bis die Aufnahme auf ein feststehendes Hindernis aufläuft und dadurch die Reibverbindung zwischen Aufnahme und Führung gelöst wird. Auf diese Weise bleibt dann die Aufnahme an einer bestimmten Stelle stehen, während die Führung weiterbewegt wird. Dadurch kann auch an einer bestimmten Stelle eine Vielzahl von Aufnahmen hintereinander aufgereiht werden. Solche Ausführungen können bei bestimmten Verwendungen der Halterung ausgenutzt werden.

Die Halterung kann durch die Auswahl der Führung und zusätzlich durch die Zahl der Aufnahmen in verschiedenster Weise modifiziert sein. So ist es beispielsweise möglich, eine bestimmte Länge der Führung vorzusehen und entlang dieser Führung so viel Aufnahmen wie möglich anzuordnen. Es können jedoch auch bei gleicher Führungslänge weniger Aufnahmen als theoretisch möglich vorgesehen sein, so daß bei geeigneter Verbindung zwischen Aufnahmen und Führung die Aufnahmen entlang der Führung beweglich sind. So kann beispielsweise die Führung zwischen zwei Stationen einer Behandlungsvorrichtung für plattenförmige Gegenstände angeordnet sein und dabei eine Verschiebung der Aufnahmen entlang dieser Führung zwischen den beiden Stationen vorgesehen sein. Insbesondere kann es sich bei der Führung um eine sogenannte Endlosführung handeln, wie beispielsweise ein in sich geschlossenes Führungsband, wobei die Aufnahmen beispielsweise durch Bewegung des Bandes selbst bewegbar sind. Bei solchen Ausführungsformen können die Aufnahmen entweder einen festen Abstand zueinander besitzen, oder entlang der Führung frei beweglich sein. Auch eine ortsfeste, gegebenenfalls lückenlose Positionierung der Aufnahmen auf der Führung ist möglich.

In Weiterbildung besitzen die Aufnahmen Klemmeinrichtungen für die plattenförmigen Gegenstände. Die Aufnahmen können auch von diesen Klemmeinrichtungen selbst gebildet sein. Die Klemmeinrichtungen dienen dazu, die plattenförmigen Gegenstände, beispielsweise an ihrem Randbereich in der Halterung zu fixieren. Bei solchen Klemmeinrichtungen kann es sich beispielsweise um Klemmbacken oder Klammern handeln, bei denen die plattenförmigen Gegenstände durch Öffnen und Schließen beispielsweise in Aufnahmeschlitze eingebracht bzw. aus diesen wieder entfernt werden können. Dabei können die Klemmeinrichtungen mit Hilfe einer Steuerung automatisch betätigt werden, so daß beispielsweise ein taktweises Beladen und Entladen der Halterung ermöglicht wird.

Es ist bevorzugt, wenn es sich bei den Klemmeinrichtungen um selbstklemmende Halteglieder handelt, die vorzugsweise mechanisch auslösbar sind. Auf diese Weise sind die plattenförmigen Gegenstände besonders einfach in der Halterung fixierbar. Bei einem solchen Halteglied kann es sich beispielsweise um eine Haltestange oder Halteschiene handeln. Diese kann beispielsweise nach Einbringen des plattenförmigen Gegenstandes in die Aufnahme entlang einer als Schräge ausgebildeten Seitenwand der Aufnahme bewegt werden. Durch diese Bewegung wird der plattenförmige Gegenstand zwischen der an der Schräge anliegenden Führungsstange oder -schiene und der gegenüberliegenden Aufnahmewand verklemmt und damit fixiert. Die Bewegung der Haltestange bzw. -schiene wird dabei vorzugsweise mechanisch ausgelöst, beispielsweise durch einen oder mehrere an der Stange oder Schiene angreifende Hebel, die das Halteglied gegen die Schräge der Aufnahme drücken. So können beispielsweise zwei Hebel an freie, über die Abmessungen der Aufnahme hinausragende Enden einer Halterstange angreifen. Für die Entnahme des plattenförmigen Gegenstandes wird das Halteglied entlastet und damit die Klemmung aufgehoben. Die Bewegung der Haltestange kann selbstverständlich auch auf andere Weise direkt betätigt sein, wie beispielsweise pneumatisch, hydraulisch oder magnetisch. Ein einfaches Verklemmen der Haltestange bzw. -schiene durch deren Gewicht selbst (Schwerkraft) ist ebenfalls denkbar. In diesem Fall muß die Klemmung durch eine geeignete direkte Betätigung wieder aufgehoben werden.

Die Haltestange bzw. -schiene kann in jeder beliebigen geeigneten Weise, wie beispielsweise rund, oval oder rechteckig ausgebildet sein.

Die erfindungsgemäße Halterung ist vorzugsweise so ausgebildet, daß jede Aufnahme für einen plattenförmigen Gegenstand vorgesehen ist. Dadurch wird erreicht, daß die plattenförmigen Gegenstände in gegenseitigem Abstand zueinander gehalten sind. Gegenseitige Beschädigungen sind damit weitgehend ausgeschlossen.

Wie bereits beschrieben, kann die erfindungsgemäße Halterung unter Beibehaltung der hängenden Anordnung der plattenförmigen Gegenstände, in verschiedenster Weise ausgestaltet sein. Es ist bevorzugt, wenn es sich bei der Halterung um ein Magazin handelt, in dem eine Mehrzahl, d. h. eine bestimmte Anzahl, von Aufnahmen nebeneinander angeordnet sind. Auf diese Weise können in einer Halterung eine bestimmte Anzahl von plattenförmigen Gegenständen, gegebenenfalls mit festem Abstand zueinander, untergebracht werden. Solche Halterungen sind besonders dann von Vorteil, wenn einzelne Behandlungsstationen nicht durch Führungen miteinander verbunden sind, sondern die plattenförmigen Gegenstände in der Halterung von einer Station zur anderen befördert werden. Solche Magazine sind auch besonders gut als sogenannte Puffer oder zur längeren Lagerung von plattenförmigen Gegenständen geeignet.

Die erfindungsgemäße Einrichtung zur Entnahme und/oder zum Beschicken von plattenförmigen Gegenständen, insbesondere Leiterplatten und Formätzteilen, von einer bzw. auf eine Transport- und/oder Behandlungsvorrichtung, vorzugsweise Transport- und/oder Behandlungsstrecke, ist dadurch gekennzeichnet, daß sie mindestens eine erfindungsgemäße Halterung der bereits beschriebenen Art aufweist.

Die erfindungsgemäße Halterung kann sich dabei an jeder beliebigen Stelle der Einrichtung befinden, wobei das Beladen bzw. Entladen der plattenförmigen Gegenstände in bzw. aus der Halterung zweckmäßig von unten her erfolgt. Dementsprechend ist dann die Einrichtung ausgestaltet.

Bei der erfindungsgemäßen Einrichtung ist die Halterung insbesondere oberhalb der Transport- und/oder Behandlungsvorrichtung, vorzugsweise oberhalb der Transport- und/oder Behandlungsstrecke angeordnet. Auf diese Weise ist die Entnahme oder das Beschicken der Halterung (von unten) erleichtert.

In Weiterbildung weist die erfindungsgemäße Einrichtung mindestens ein Überführungsmittel auf, das die Überführung der plattenförmigen Gegenstände von der Transport- und/oder Behandlungsvorrichtung in die Halterung und/oder von der Halterung in die Transport- und/oder Behandlungsvorrichtung vornimmt. Dieses Überführungsmittel ist vorzugsweise an einer vertikalen Achse angeordnet.

In Weiterbildung ist das Überführungsmittel zumindest vertikal bewegbar, wobei dies zweckmäßigerweise dadurch erreicht wird, daß es entlang der vertikalen Achse verschiebbar angeordnet oder gelagert ist. Dadurch kann das Überführungsmittel zwischen der Ebene, aus der der plattenförmige Gegenstand in der Vorrichtung entnommen wird, vertikal herausbewegt bzw. in diese hineinbewegt werden.

Die plattenförmigen Gegenstände werden üblicherweise aus einer horizontalen Transport- und/oder Behandlungsebene in die erfindungsgemäße Halterung überführt, in der die plattenförmigen Gegenstände hängend gelagert sind. Deshalb ist das Überführungsmittel zweckmäßig so ausgestaltet, daß es aus einer horizontalen Ebene um 90° in eine vertikale Ebene schwenkbar ist und umgekehrt. Auf diese Weise kann es die für ein Beladen oder Entladen notwendigen Bewegungsabläufe ausführen. Selbstverständlich ist es bei der Erfindung jedoch auch möglich, daß das Überführungsmittel um jeden beliebigen anderen Winkel schwenkbar ist, um damit beispielsweise plattenförmige Gegenstände von nicht horizontal laufenden Transport- und/oder Behandlungsebenen zu entnehmen bzw. auf diese aufzulegen.

Insbesondere für den Fall, daß der plattenförmige Gegenstand von der gleichen Entnahme- und/oder Beschickungseinrichtung von einer horizontal laufenden Strecke in die Halterung überführt und aus der Halterung auf die gleiche Strecke wieder in Laufrichtung der Strecke abgesetzt werden soll, ist es zweckmäßig, wenn das Überführungsmittel aus einer horizontalen Ebene um 180° in eine horizontale Ebene schwenkbar ist. Dieses Verschwenken soll dabei insbesondere so erfolgen können, daß eine Verschwenkung aus der horizontalen Ebene um 90° in die Vertikale und dann aus dieser Vertikalen um weitere 90° in die horizontale Ebene möglich ist. Dadurch können auch solche Bewegungsabläufe ausgeführt werden.

Das Überführungsmittel kann den plattenförmigen Gegenstand für die Dauer der Überführung in beliebiger Weise festlegen. Es ist jedoch bevorzugt, wenn das Überführungsmittel Saugeinrichtungen zur Festlegung der plattenförmigen Gegenstände aufweist. Durch solche Saugeinrichtungen wird erreicht, daß das Überführungsmittel ohne Probleme zusammen mit dem plattenförmigen Gegenstand verschwenkt oder verkippt werden kann. Insbesondere handelt es sich bei der Saugeinrichtung um eine sogenannte Saugerplatte.

In vielen Fällen sind an der Transport- und/oder Behandlungsvorrichtung einzelne Riemenantriebe zur Bewegung der plattenförmigen Gegenstände vorgesehen. Deshalb ist es nach der Erfindung bevorzugt, wenn das Überführungsmittel derart ausgebildet ist, daß es das Überführen der plattenförmigen Gegenstände von einer oder in eine solche Riemenantriebe aufweisende Transport- und/oder Behandlungsstrecke ermöglicht. Zu diesem Zweck besitzt das Überführungsmittel insbesondere fingerförmige Abschnitte, die beispielsweise zur Aufnahme des plattenförmigen Gegenstandes von unten zwischen den einzelnen Riemenantrieben hindurchgeführt werden.

In Weiterbildung besitzt die Einrichtung zwei Überführungsmittel, von denen das eine zum Überführen der plattenförmigen Gegenstände von einer Transport- und/oder Behandlungsvorrichtung in eine Halterung und das zweite Überführungsmittel zum Überführen der plattenförmigen Gegenstände aus einer Halterung auf eine Transport- und/oder Behandlungsvorrichtung vorgesehen ist. Durch eine solche Einrichtung wird ein gleichzeitiges Beladen und Entladen von Halterungen, gegebenenfalls sogar der gleichen Halterung ermöglicht.

Schließlich können die erfindungsgemäßen Einrichtungen zusätzlich Transportmittel für die Halterungen besitzen. Diese Transportmittel sind beispielsweise dazu vorgesehen, die Halterungen zwischen verschiedenen Transport- und/oder Behandlungsvorrichtungen zu transportieren. Auch ein Transport der Halterungen innerhalb derselben Transport- und/oder Behandlungsvorrichtung, beispielsweise zwischen der Beschickungs- und der Entnahmestation wird dadurch ermöglicht. Bei den Transportmitteln kann es sich um Transportwagen oder Transportgestelle handeln, in denen die Halterungen in leerem, teilweise gefülltem oder vollständig gefülltem Zustand transportiert werden. Es ist auch möglich, oberhalb einer erfindungsgemäßen Einrichtung Transportmittel vorzusehen, mit deren Hilfe die an einem Ende einer Transport- und/oder Behandlungsvorrichtung entleerten Halterungen an das andere Ende der Vorrichtung bewegt werden, um dort die Halterungen wieder mit plattenförmigen Gegenständen zu beladen.

Die Erfindung betrifft weiterhin eine beliebige Vorrichtung zur Behandlung von plattenförmigen Gegenständen, insbesondere von Leiterplatten und Formätzteilen, bei der eine der beschriebenen erfindungsgemäßen Halterungen und/oder eine der beschriebenen erfindungsgemäßen Einrichtungen zur Entnahme und/oder zum Beschicken von plattenförmigen Gegenständen vorgesehen ist. Die Arbeitsweise solcher Vorrichtungen wird durch den Einsatz der erfindungsgemäßen Halterungen und Einrichtungen verbessert.

Schließlich umfaßt die Erfindung noch die Verwendung der erfindungsgemäßen Halterung in einem beliebigen Verfahren zur Behandlung von plattenförmigen Gegenständen, insbesondere von Leiterplatten und Formätzteilen. Dabei können die Halterungen in jedem beliebigen Verfahrensschritt in geeigneter Weise eingesetzt werden. So kann die Halterung zum Beschicken vor einzelnen Verfahrensschritten oder zur Entnahme nach einzelnen Verfahrensschritten verwendet werden. Bevorzugt ist auch eine Verwendung der Halterung als sogenannter Puffer, bei der die plattenförmigen Gegenstände zwischen einzelnen Behandlungsschritten in der Halterung zwischengelagert werden, um so beispielsweise Staus zwischen einzelnen Behandlungsstationen zu vermeiden.

Die beschriebenen Merkmale und weitere Merkmale der Erfindung ergeben sich aus der nachfolgenden Beschreibung von bevorzugten Ausführungsformen in Verbindung mit den Unteransprüchen und den Zeichnungen. Hierbei können die einzelnen Merkmale jeweils für sich oder zu mehreren in Kombination miteinander verwirklicht sein.

In den Zeichnungen zeigen
- Fig. 1: eine schematische Teilseitenansicht einer erfindungsgemäßen Halterung,
- Fig. 2: eine schematische Seitenansicht einer erfindungsgemäßen Entnahme- und/oder Beschickungseinrichtung,
- Fig. 3: eine schematische Seitenansicht einer weiteren erfindungsgemäßen Entnahme- und/oder Beschickungseinrichtung, und
- Fig. 4: eine schematische Seitenansicht einer dritten erfindungsgemäßen Entnahme- und/oder Beschickungseinrichtung.

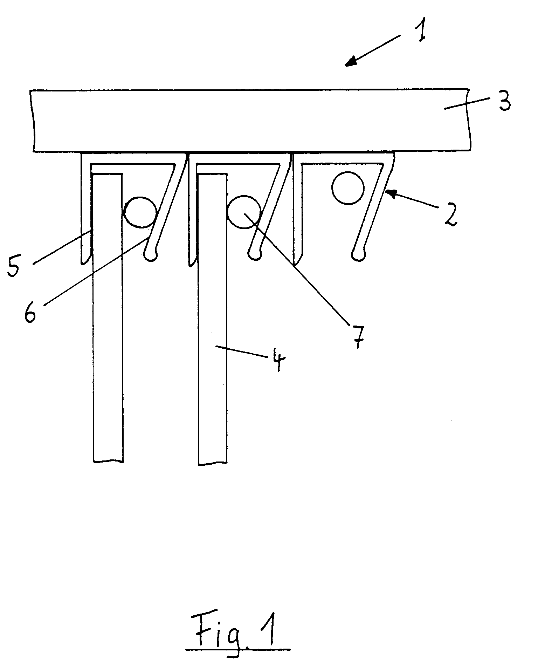

Bei der in Figur 1 dargestellten Halterung 1 sind Aufnahmen 2 an einer Führung 3 angeordnet. Wie bereits ausgeführt, kann es sich bei dieser Führung 3 beispielsweise um eine Führungsschiene, einen Führungsstab oder ein Führungsband handeln. Auch die Befestigung der Aufnahmen 2 an der Führung 3 ist gemäß der Erfindung freigestellt. So können die Aufnahmen 2 mit der Führung 3, beispielsweise durch Verschraubung fest verbunden sein. Es ist jedoch ebenfalls möglich, die Aufnahmen 2 an einer Führung 3 beweglich vorzusehen.

In Figur 1 sind drei Aufnahmen 2 dargestellt, von denen zwei mit einer Leiterplatte 4 bestückt sind, die aus den Aufnahmen 2 heraus nach unten hängend angeordnet sind. Die in Figur 1 rechte äußere Aufnahme 2 ist leer.

Die in Figur 1 dargestellte Aufnahme 2 besitzt eine gerade Anlagefläche 5 für die Leiterplatte 4 sowie eine Schräge 6 zur Fixierung der Leiterplatte 4 mit Hilfe des in Figur 1 ebenfalls dargestellten Haltegliedes 7 in Form einer Haltestange. Das in Figur 1 einen runden Querschnitt aufweisende Halteglied 7 kann selbstverständlich in jeder anderen geeigneten Form, beispielsweise als Schiene mit ovalem Querschnitt ausgebildet sein.

Bei der in Figur 1 dargestellten Ausführungsform soll sich das Halteglied 7 über die gesamte Länge der Aufnahme 2 erstrecken und an deren Enden über die Abmessungen der Aufnahme 2 hinausragen. Ist die Aufnahme 2 leer, wie dies in der rechten Aufnahme 2 der Figur 1 dargestellt ist, so befindet sich das Halteglied 7 in seinem nichtausgelösten Zustand im Bereich des geschlossenen Endes der Aufnahme 2. Wird eine Leiterplatte 4 in die betreffende Aufnahme 2 eingebracht und soll dort fixiert werden, so werden die beiden freien, über die Abmessungen der Aufnahme 2 hinausragenden Enden des Haltegliedes 7 mit Hilfe von in Figur 1 nicht dargestellten Betätigungsvorrichtungen, wie beispielsweise Hebeln, gegen die Schräge 6 bzw. gegen die Leiterplatte 4 gepreßt. Dadurch wird die Leiterplatte 4 in der Aufnahme 2 fixiert.

Bei der in Figur 1 dargestellten Ausführungsform ist für jede Leiterplatte 4 eine Aufnahme 2 vorgesehen, so daß die Leiterplatten 4 mit Abstand zueinander hängend in der Halterung 1 angeordnet sind. Dabei kann sich der in Figur 1 dargestellte Ausschnitt innerhalb eines abgeschlossenen Magazins für eine bestimmte Anzahl von Leiterplatten 4 befinden. Genauso ist es möglich, daß sich dieser Ausschnitt an einer offenen Führung 3 zwischen zwei Stationen, wie beispielsweise einer Belade- und einer Entladestation befindet. Bei der Führung 3 kann es sich auch um eine sogenannte Endlosführung handeln, an der die Aufnahmen 2 frei beweglich gelagert sind.

Es sind bei der erfindungsgemäßen Halterung auch andere Klemmeinrichtungen als die dargestellten selbstklemmenden, mechanisch auslösbaren Einrichtungen einsetzbar. Auch Klammern oder Klemmbacken sind verwendbar, wobei die Leiterplatten 4 zwischen den Klammerhälften oder Backen verklemmt werden. Die dazu nötigen Kräfte können beispielsweise durch Zug- oder Druckfedern aufgebracht werden.

Schließlich sei noch erwähnt, daß die Aufnahme 2 an ihrer offenen Unterseite abgerundete Enden besitzt, damit die Leiterplatten 4, insbesondere beim Einbringen in die Aufnahme 2 nicht beschädigt werden.

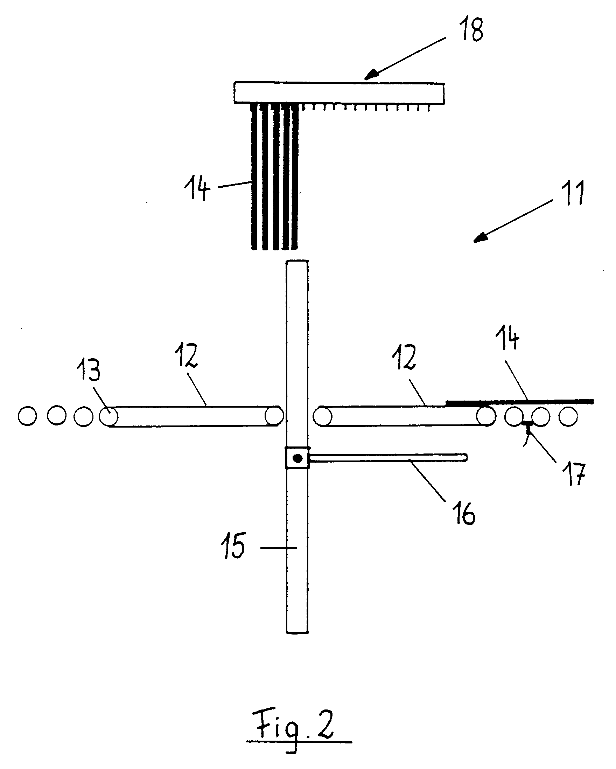

Die Entnahme- und/oder Beschickungseinrichtung 11 gemäß Figur 2 zeigt zwei Transportstrecken 12 mit Vorschüben 13, auf denen Leiterplatten 14 transportierbar sind. An den Transportstrecken 12 ist eine vertikal ausgerichtete Achse 15 vorgesehen, an der ein Überführungsmittel 16 angeordnet ist. Wenn die Transportstrecken 12 einzelne Riemenantriebe aufweisen, die in Figur 2 nicht dargestellt sind, so besitzt das Überführungsmittel 16 fingerförmige Abschnitte, mit deren Hilfe das Überführungsmittel 16 durch die Bereiche zwischen den Riemenantrieben vertikal hindurchgeführt ("gekämmt") werden kann. Bei dem Überführungsmittel 16 kann es sich um eine sogenannte Saugerplatte handeln. Schließlich ist in Figur 2 ein Sensor 17 dargestellt, mit dessen Hilfe erkennbar ist, wann Anfang bzw. Ende einer Leiterplatte 14 die betreffende Stelle der Transportstrecke 12 passiert.

Bei der in Figur 2 dargestellten Einrichtung 11 ist oberhalb der Transportstrecken 12 schematisch eine erfindungsgemäße Halterung 18 dargestellt, in die die auf der Transportstrecke 12 transportierten Leiterplatten 14 eingebracht bzw. aus der sie auf die Transportstrecke 12 überführt werden können. Bei der in Figur 2 dargestellten Ausführungsform handelt es sich bei der Halterung 18 vorzugsweise um ein Magazin mit einzelnen Aufnahmen für jeweils eine Leiterplatte 14. Es ist jedoch genauso vorstellbar, daß sich oberhalb der Transportstrecken 12 eine Führung befindet, an der eine Vielzahl von Aufnahmen entweder in festen oder mit variablen Abständen angeordnet ist. Auf diese Weise können beispielsweise mehrere der in Figur 2 dargestellten Einrichtungen 11 durch diese Führung verbunden und somit Leiterplatten 14 von einer Einrichtung in die andere Einrichtung transportiert werden. Dabei kann die Führung selbstverständlich auch als Endlosführung vorgesehen sein.

Im folgenden soll die Funktionsweise der in Figur 2 dargestellten Einrichtung beschrieben werden. Dabei kann beispielsweise eine Halterung verwendet werden, wie sie in Figur 1 ausschnittweise dargestellt ist. Bei dem im folgenden geschilderten Beispiel soll die in der Einrichtung 11 verwendete Halterung 18 als sogenannter Puffer dienen, das heißt die von der Transportstrecke 12 entnommenen Leiterplatten 14 sollen in der Halterung 18 zwischengelagert werden, so daß auf der Transportstrecke 12 vor der nächsten Behandlungsstation kein Stau an Leiterplatten 14 entsteht. Dabei können die Leiterplatten 14 aus der Halterung 18 entnommen werden, wenn die Halterung 18 vollständig oder auch nur teilweise mit Leiterplatten 14 gefüllt ist.

Zu Beginn des Verfahrensablaufes ist die oberhalb der Transportstrecke 12 angeordnete Halterung 18 leer. Wenn beispielsweise gemäß Figur 2 sich eine Leiterplatte 14 von rechts nähert, so wird durch den Sensor 17 sowohl Anfang als auch Ende der Leiterplatte 14 erkannt. Hat das Ende der Leiterplatte 14 den Sensor 17 passiert, so wird das Überführungsmittel 16 in horizontaler Stellung entlang der Achse 15 vertikal angehoben. Dabei "kämmt" das Überführungsmittel 16 durch die rechte Transportstrecke 12 unter Mitnahme der Leiterplatte 14. Handelt es sich bei dem Überführungsmittel 16 um eine sogenannte Saugerplatte, so wird durch die ausgeübte Saugwirkung die Leiterplatte 14 am Überführungsmittel 16 festgelegt.

Nachdem das Überführungsmittel 16 die Leiterplatte 14 übernommen hat, wird das Überführungsmittel 16 aus der zur Transportstrecke 12 parallelen Horizontale um 90° in die Vertikale verschwenkt. Anschließend wird die Leiterplatte 14 durch das Überführungsmittel 16 in die erste (linke) offene Aufnahme der Halterung 18 eingebracht. Dann wird die Leiterplatte 14 in der Aufnahme beispielsweise in der gemäß Figur 1 dargestellten Weise fixiert.

Anschließend fährt das Überführungsmittel 16 in vertikaler Stellung an der Achse 15 entlang nach unten, bis sich das Überführungsmittel 16 vollständig unterhalb der horizontalen Ebene der rechten Transportstrecke 12 befindet. Dann wird das Überführungsmittel 16 aus seiner vertikalen Stellung wieder um 90° in die zur Transportstrecke 12 parallele Horizontale verschwenkt. Damit ist ein Beladevorgang (Beschickungsvorgang) für eine Leiterplatte 14 in die Halterung 18 abgeschlossen.

Inzwischen hat sich eine weitere Leiterplatte 14 über den Sensor 17 hinwegbewegt und durch diesen Vorgang ausgelöst, wird das Überführungsmittel 16 wiederum entlang der Achse 15 vertikal nach oben bewegt, um diese zweite Leiterplatte 14 zu übernehmen und in der bereits beschriebenen Weise in die nächste, das heißt in die neben der gerade beladenen Aufnahme rechts anschließende Aufnahme zu überführen. Zu diesem Zweck wird die Halterung vorab um einen Platz weitergetaktet. Diese einzelnen Beladungsschritte werden so lange wiederholt, bis die Halterung 18 vollständig gefüllt ist, oder kein weiterer Bedarf besteht, zusätzliche Leiterplatten 14 in die Halterung 18 zu überführen. In Figur 2 ist die Einrichtung in einer Stellung gezeigt, in der fünf Platten 14 in der Halterung 18 abgelegt sind und die sechste Platte 14 gerade über den Sensor 17 läuft.

Jeder Beladevorgang für eine Leiterplatte 14 wird dadurch ausgelöst, daß der Sensor 17 das Herannahen einer Leiterplatte 14 meldet. Wird keine Leiterplatte 14 herantransportiert, verharrt das Überführungsmittel 16 in seiner Stellung unterhalb der rechten Transportstrecke 12. Die Einrichtung arbeitet dann besonders effektiv, wenn die Leiterplatten 14 in regelmäßigen Abständen herangeführt werden und somit ein automatisches (taktweises) Beladen der Halterung 18 erfolgt.

Ist die Halterung 18 entweder teilweise oder vollständig mit Leiterplatten 14 gefüllt, so kann sie beispielsweise zu einer anderen Station einer Behandlungsvorrichtung für Leiterplatten gebracht werden. Die in Figur 2 dargestellte Einrichtung 11 ist jedoch auch in der Lage, die befüllte Halterung 18 wieder zu entladen. Zu diesem Zweck wird die befüllte Halterung 18 wieder in ihre Ausgangsstellung zurückgefahren. Das unterhalb der Transportstrecken 12 angeordnete Überführungsmittel wird entlang der Achse 15 vertikal nach unten gefahren und um 90° in die Vertikale verschwenkt. Dann wird es entlang der Achse 15 in vertikaler Stellung bis zur Halterung 18 hinauf verschoben und dort eine Leiterplatte 14 aus der am weitesten links liegenden befüllten Aufnahme der Halterung 18 entnommen, das heißt diese Leiterplatte 14 wird am Überführungsmittel 16, beispielsweise mit Hilfe der Saugplatte festgelegt.

Anschließend wird das Überführungsmittel 16 wieder um 90° in die zu den Transportstrecken 12 parallele Horizontale verschwenkt, wobei dieses Verschwenken diesmal allerdings auf die andere Seite der Achse 15 erfolgt. Dies bedeutet, daß die Leiterplatte 14 relativ zur Achse 15 auf der linken Transportstrecke 12 abgelegt wird, das heißt auf der anderen als sie von der Transportstrecke 12 entnommen wurde.

Das Ablegen der Leiterplatte 14 auf der linken Transportstrecke 12 erfolgt dadurch, daß das Überführungsmittel 16 in horizontaler Stellung durch die Ebene der Transportstrecke 12 geführt wird. Anschließend wird das Überführungsmittel 16 entlang der Achse 15 nach unten gefahren und anschließend aus der Horizontalenebene um 90° wieder in die Vertikale verschwenkt. Durch erneutes Hochfahren des Überführungsmittels 16 entlang der Achse 15 und erneutes Durchführen der weiteren Verfahrensschritte kann die nächste Leiterplatte 14 aus der Halterung 18 entnommen und so sukzessive die Halterung 18 wieder entleert werden. Die Entnahme erfolgt in der Weise, daß die abgelegten Platten 14 in der Reihenfolge aus der Halterung 18 entnommen werden, in der sie abgelegt wurden, ohne daß ein Drehen oder Wenden der Platten 14 nötig wäre.

Es ist selbstverständlich, daß dieses Prinzip zum Beschicken oder Entnehmen der Leiterplatten nicht nur bei dem genannten Puffermagazin, sondern auch bei anderen erfindungsgemäßen Halterungen oder Einrichtungen verwendet werden kann. Dabei können die Leiterplatten beispielsweise aus den Aufnahmen, die an einer Endlosführung angeordnet sind, entnommen werden.

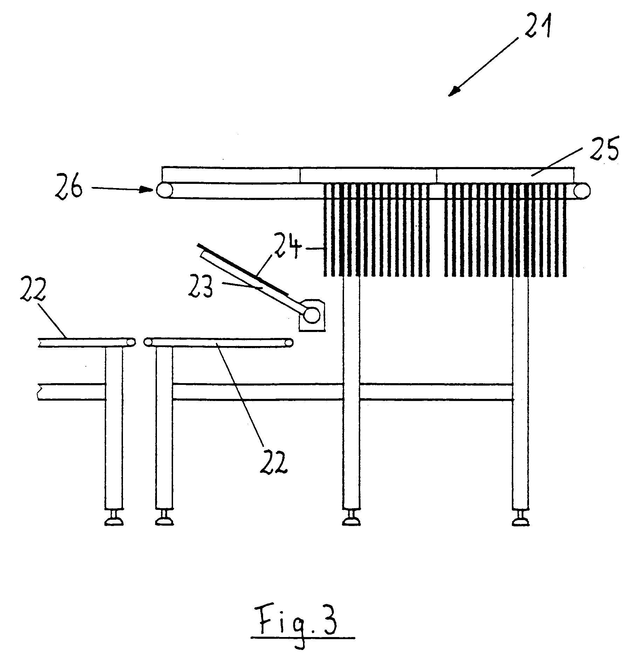

In Figur 3 ist eine weitere erfindungsgemäße Entnahme- und/oder Beschickungseinrichtung 21 dargestellt. Dabei können Leiterplatten 24 mit Hilfe eines Überführungsmittels 23 von einer Transportstrecke 22 entnommen werden. Dabei ist das Überführungsmittel 23 zweckmäßigerweise entlang einer vertikalen Achse verschiebbar, die in Figur 3 nicht dargestellt ist. Die Leiterplatten 24 werden gemäß Figur 3 von der Transportstrecke 22 mit dem Überführungsmittel 23 in Halterungen 25 überführt. Die in Figur 3 dargestellte Einrichtung 21 zeigt drei Halterungen 25 in Form von Magazinen, die jeweils 16 Leiterplatten 24 aufnehmen können. Mit Hilfe in Figur 3 nur angedeuteter Verschiebeeinrichtungen 26 sind die Halterungen 25 in geeigneter Weise weiterbewegbar, um die einzelnen Aufnahmen der Halterung 25 nacheinander mit Leiterplatten 24 zu beladen.

Bei der in Figur 3 dargestellten Einrichtung 21 werden die einzelnen Halterungen 25 von rechts nach links mit Leiterplatten 24 beladen. Die Einrichtung 21 ist dabei in Figur 3 in der Position dargestellt, in der die 15. Leiterplatte 24 in die zweite Halterung 25 von rechts eingebracht wird. Sobald ein in Figur 3 nicht dargestellter Sensor das Herannahen der Leiterplatte 24 meldet, wird das Überführungsmittel 23 in horizontaler Stellung entlang der in Figur 3 nicht dargestellten vertikalen Achse nach oben gefahren, um die Leiterplatte 24 von der Transportstrecke 22 zu übernehmen. Bei einer mit einzelnen Bandantrieben ausgestatteten Transportstrecke 22 kämmt das in entsprechender Weise ausgestaltete Überführungsmittel 23 dabei durch die Transportstrecke 22 hindurch und übernimmt auf diese Weise die Leiterplatte 24. Bei dem Überführungsmittel 23 kann es sich um eine sogenannte Saugerplatte handeln, mit deren Hilfe die Leiterplatte 24 am Überführungsmittel 23 festgelegt wird. Anschließend wird das Überführungsmittel 23 in der bereits bezüglich Figur 2 geschilderten Weise um 90° in die Vertikale verschwenkt und die Leiterplatte 24 in die nächste freie Aufnahme der Halterung 25 eingebracht.

Sobald eine Halterung 25 vollständig oder auch teilweise befüllt ist, kann sie mit Hilfe eines Transportwagens zu einer anderen Vorrichtung oder Station gebracht werden. Weitere leere Halterungen 25 können beispielsweise automatisch oder von Hand von einem hinter den Verschiebeeinrichtungen angeordneten Stapel mit Halterungen 25 ergänzt werden, sobald eine befüllte Halterung 25 entnommen wurde.

Die gemäß Figur 3 dargestellte Einrichtung 21 kann in entsprechender Weise zum Entnehmen von Leiterplatten 24 aus den Halterungen 25 verwendet werden. Dabei werden die Halterungen 25 in vollständig oder teilweise befülltem Zustand wieder entleert, wobei die sich am weitesten links befindende Leiterplatte 24 zuerst entnommen wird. Um zu gewährleisten, daß die zuerst abgelegte Leiterplatte 24 auch wieder als erste entnommen wird, können die Halterungen 25 in umgekehrter Richtung in die Einrichtung 21 eingebracht werden, was beispielsweise durch einfaches Drehen des Transportwagens geschehen kann. Die einzelnen Leiterplatten 24 werden von dem Überführungsmittel 23 übernommen und nach einer Schwenkung um 90° auf der Transportstrecke 22 abgelegt und nach links, also in die andere Richtung als beim Zuführen abtransportiert. Vollständig entleerte Halterungen 25 können in entsprechender Weise von Hand oder automatisch auf einen der Einrichtung 21 zugeordneten Stapel abgelegt werden.

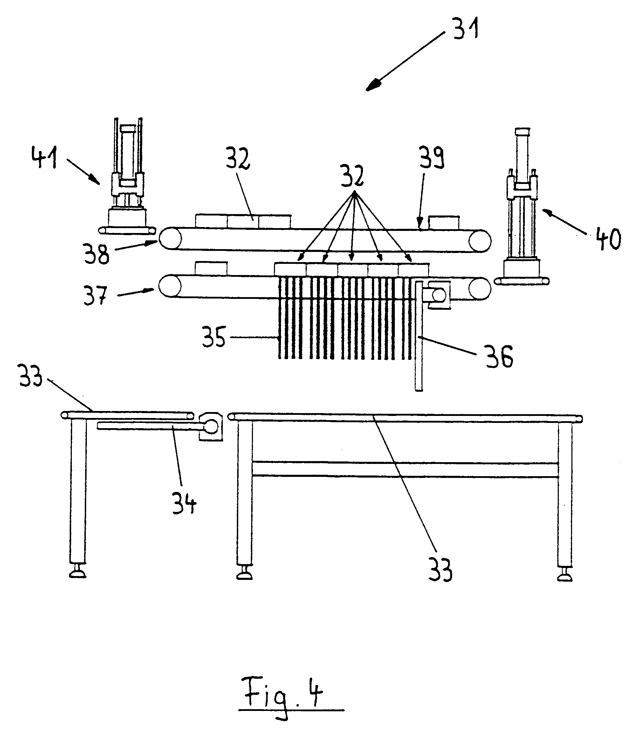

Figur 4 zeigt eine dritte Entnahme- und/oder Beschickungseinrichtung 31 nach der Erfindung. Bei dieser Einrichtung 31 ist eine erfindungsgemäße Halterung 32 oberhalb einer Transportstrecke 33 angeordnet. Ferner weist die Einrichtung 31 ein Überführungsmittel 34 zum Überführen von Leiterplatten 35 in die Halterung 32 und ein weiteres Überführungsmittel 36 zum Überführen der Leiterplatten 35 aus der Halterung 32 auf die Transportstrecke 33 auf. Die genannten Definitionen gelten dann, wenn die Einrichtung 31 in der Weise betrieben wird, daß die Leiterplatten 35 gemäß Figur 4 von links herangeführt werden, in der Halterung 32 abgelegt und anschließend bei Bedarf auf der rechten Seite der Transportstrecke 33 aufgelegt und nach rechts weitertransportiert werden. Selbstverständlich kann die Vorrichtung auch umgekehrt, das heißt "von rechts nach links" betrieben werden.

Die in Figur 4 dargestellten Halterungen 32 sind als Magazine mit einer Aufnahmekapazität von vier Leiterplatten 35 ausgebildet. Die Halterungen 32 werden von einer in Figur 4 nicht näher dargestellten Fördereinrichtung 37 bewegt, die die erste leere Aufnahme der sich jeweils an der Reihe befindenden Halterung 32 in die zur Beladung vorgesehene Stellung oberhalb des Überführungsmittels 34 (Zuführstation) bewegt. Die mit den Leiterplatten 35 befüllten Halterungen 32 werden bis zum Überführungsmittel 36 (Entnahmestation) bewegt und anschließend bei Bedarf eine Leiterplatte 35 aus der sich an der Reihe befindenden Halterung 32 entnommen. Dabei wird in der bereits beschriebenen Weise eine zuerst in die Halterung 32 eingebrachte Leiterplatte 35 auch wieder als erste aus der Halterung 32 entnommen.

Schließlich sind in der Figur 4 oberhalb der Halterung 32 Transportmittel 38 zum Transport leerer Halterungen 32 zwischen dem Überführungsmittel 36 (Entnahmestation) und dem Überführungsmittel 34 (Zuführstation) vorgesehen. Diese Transportmittel 38 bestehen im wesentlichen aus einer Fördereinrichtung 39, beispielsweise in Form einer Stauförderkette, die die leeren Halterungen 32 transportiert, und einer Hubstation 40 sowie einer Senkstation 41, die die leeren Halterungen 32 aus der Ebene, in der sie beladen bzw. entladen werden, auf die Ebene des Transportmittels 38 bringt bzw. umgekehrt. Auf diese Weise stehen an der Zuführstation (Überführungsmittel (34)) stets genügend leere Halterungen 32 zur weiteren Befüllung zur Verfügung.

Im übrigen sei erwähnt, daß es sich bei der Fördereinrichtung 37 zur vorzugsweise getakteten Bewegung der Halterungen 32 beim Beladen und Entladen ebenfalls um eine der eben genannten Stauförderketten handeln kann. Dabei sind links und rechts zwei Ketten angebracht, zwischen denen die Leiterplatten 35 nach unten aus der Halterung 32 heraushängen.

Die in Figur 4 dargestellte Einrichtung 31 funktioniert im wesentlichen nach dem folgenden Verfahren. Im folgenden ist die Halterung 32 als sogenannter Puffer vorgesehen, der immer dann befüllt wird, wenn ein Stau der Leiterplatten 35 auf der Transportstrecke 33 auftritt oder aufzutreten droht. Dann wird die Halterung 32 so lange mit Leiterplatten 35 befüllt, bis der Stau abgebaut ist. Umgekehrt werden immer dann Leiterplatten 35 aus der Halterung 32 entnommen, wenn die regelmäßige Folge von Leiterplatten 35 auf der Transportstrecke 33 abbricht, das heißt, wenn Lücken auftreten. Dieser sogenannte "atmende Puffer" wird also nur bei Bedarf zugeschaltet, ansonsten laufen die Leiterplatten 35 auf der Transportstrecke 33 direkt von links nach rechts durch.

Gemäß Figur 4 erfolgt das Einbringen der Leiterplatten 35 in die Halterung 32 in der bereits beschriebenen Weise. Nähert sich eine von der Transportstrecke 33 zu entfernende Leiterplatte 35 von links, übernimmt das Überführungsmittel 34 in seiner horizontalen Stellung die Leiterplatte 35. Das Herannahen der Leiterplatte 35 kann beispielsweise durch einen in Figur 4 nicht dargestellten Sensor angezeigt werden. In gleicher Weise kann das Überführungsmittel 34 kammartig ausgebildet sein und die Leiterplatte 35 durch Saugeinrichtungen festlegen. Anschließend wird das Überführungsmittel 34 um 90° in die Vertikale verkippt und die Leiterplatte 35 in die nächste freie Aufnahme der Halterung 32 eingebracht. Zu diesem Zweck kann das Überführungsmittel 34 zusätzlich entlang einer in Figur 4 nicht gezeigten vertikalen Achse bewegt werden. Anschließend wird das Überführungsmittel 34 in seiner vertikalen Stellung bis unter die Ebene der Transportstrecke 33 bewegt und wieder um 90° in seine Horizontale verkippt. In entsprechender Weise kann durch das Überführungsmittel 36 eine Leiterplatte 35 aus der Halterung 32 entnommen und auf der Transportstrecke 33 abgelegt werden. Dazu übernimmt das Überführungsmittel 36 die Leiterplatte 35, beispielsweise mit Hilfe seiner Saugeinrichtungen. Dann wird das Überführungsmittel 36 aus der Vertikalen um 90° in die Horizontale verkippt und anschließend entlang einer in Figur 4 ebenfalls nicht dargestellten vertikalen Achse bis etwa auf die Höhe der Transportstrecke 33 nach unten gefahren. Dort wird die Leiterplatte 35 auf die Transportstrecke 33 abgelegt. Anschließend wird das Überführungsmittel 36 in seiner horizontalen Stellung wieder nach oben gefahren und um 90° in die Vertikale gekippt.

Vollständig entleerte Halterungen 32 (Kassetten) werden durch die Hubstation 40 auf die Fördereinrichtung 39 gehoben und dort auf die linke Seite dieser Fördereinrichtung transportiert. Dort werden die leeren Halterungen 32 mit Hilfe der Senkstation 41 wieder auf die untere Arbeitsebene abgesenkt. Auf diese Weise läßt sich ein kontinuierlicher Aufstapel/Abstapelvorgang erreichen.

## Patentansprüche

1. Halterung für plattenförmige Gegenstände, insbesondere Leiterplatten und Formätzteile, mit mindestens einer Aufnahme (2) für mindestens einen plattenförmigen Gegenstand (4), dadurch gekennzeichnet, daß die plattenförmigen Gegenstände (4) in der Halterung (1) hintereinander hängend, vorzugsweise mit gegenseitigem Abstand zueinander anordenbar sind.

2. Halterung nach Anspruch 1, dadurch gekennzeichnet, daß die Halterung (1) mindestens eine Führung (3) für die Aufnahmen (2), vorzugsweise mindestens ein Führungsband, eine Führungsschiene oder Führungsstange aufweist, wobei insbesondere die Aufnahmen (2) entlang der Führung (3) verschiebbar sind.

3. Halterung nach Anspruch 2, dadurch gekennzeichnet, daß die Aufnahmen (2) entlang der Führung (3) in sich wiederholenden, vorzugsweise regelmäßigen Abständen anordenbar sind.

4. Halterung nach Anspruch 2 oder Anspruch 3, dadurch gekennzeichnet, daß die Aufnahmen entlang der Führung reibschlüssig angeordnet sind, wobei insbesondere die Aufnahmen bei Aufbringen einer ausreichenden Kraft entlang der Führung verschiebbar sind.

5. Halterung nach einem der Ansprüche 2 bis 4, dadurch gekennzeichnet, daß die Führung in sich geschlossen als Endlosführung ausgebildet ist.

6. Halterung nach einem der vorhergehenden Ansprüche, dadurch gekennzeichnet, daß die Aufnahmen Klemmeinrichtungen für die plattenförmigen Gegenstände aufweisen oder von diesen Klemmeinrichtungen gebildet sind, wobei insbesondere die Klemmeinrichtung ein selbstklemmendes, vorzugsweise mechanisch auslösbares Halteglied (7) ist.

7. Halterung nach einem der vorhergehenden Ansprüche, dadurch gekennzeichnet, daß jede Aufnahme (2) für einen plattenförmigen Gegenstand (4) vorgesehen ist.

8. Halterung nach einem der vorhergehenden Ansprüche, dadurch gekennzeichnet, daß die Halterung als Magazin mit einer Mehrzahl von Aufnahmen ausgebildet ist.

9. Einrichtung zur Entnahme und/oder zum Beschicken von plattenförmigen Gegenständen, insbesondere Leiterplatten und Formätzteilen, von einer bzw. auf eine Transport- und/oder Behandlungsvorrichtung, vorzugsweise Transport- und/oder Behandlungsstrecke, dadurch gekennzeichnet, daß sie mindestens eine Halterung nach einem der vorhergehenden Ansprüche aufweist.

10. Einrichtung nach Anspruch 9, dadurch gekennzeichnet, daß die Halterung (18) oberhalb der Transport- und/oder Behandlungsvorrichtung angeordnet ist.

11. Einrichtung nach Anspruch 9 oder Anspruch 10, dadurch gekennzeichnet, daß sie mindestens ein Überführungsmittel (16) für das Überführen der plattenförmigen Gegenstände (14) von der Transport- und/oder Behandlungsvorrichtung in die Halterung (18) und gegebenenfalls umgekehrt aufweist, wobei insbesondere das Überführungsmittel (16) an einer vertikalen Achse (15) angeordnet ist.

12. Einrichtung nach Anspruch 11, dadurch gekennzeichnet, daß das Überführungsmittel (16) mindestens vertikal bewegbar ist, wobei es insbesondere entlang der vertikalen Achse (15) verschiebbar angeordnet, vorzugsweise verschiebbar gelagert ist.

13. Einrichtung nach Anspruch 11 oder Anspruch 12, dadurch gekennzeichnet, daß das Überführungsmittel (16) aus einer horizontalen Ebene um 90° in eine vertikale Ebene schwenkbar ist und umgekehrt, wobei insbesondere das Überführungsmittel (16) aus einer horizontalen Ebene über die Vertikale um 180° wieder in die horizontale Ebene schwenkbar ist.

14. Einrichtung nach einem der Ansprüche 11 bis 13, dadurch gekennzeichnet, daß das Überführungsmittel Saugeinrichtungen zur Festlegung der plattenförmigen Gegenstände aufweist, insbesondere eine Saugerplatte ist.

15. Einrichtung nach einem der Ansprüche 11 bis 14, dadurch gekennzeichnet, daß das Überführungsmittel zum Überführen der plattenförmigen Gegenstände von einer oder in eine einzelne Riemenantriebe aufweisenden Transport- und/oder Behandlungsstrecke (12) ausgebildet ist, wobei es insbesondere fingerförmige Abschnitte aufweist.

16. Einrichtung nach einem der Ansprüche 11 bis 15, dadurch gekennzeichnet, daß sie ein Überführungsmittel (34) zum Überführen der plattenförmigen Gegenstände von einer Transport- und/oder Behandlungsvorrichtung in eine Halterung und ein Überführungsmittel (36) zum Überführen der plattenförmigen Gegenstände aus einer Halterung auf eine Transport- und/oder Behandlungsvorrichtung aufweist.

17. Einrichtung nach einem der Ansprüche 9 bis 16, dadurch gekennzeichnet, daß sie Transportmittel (38) für die Halterungen zum Transport der Halterungen zwischen verschiedenen Transport- und/oder Behandlungsvorrichtungen und/oder innerhalb derselben Transport- und/oder Behandlungsvorrichtung aufweist.

18. Vorrichtung zur Behandlung von plattenförmigen Gegenständen, insbesondere Leiterplatten und Formätzteilen, gekennzeichnet durch eine Halterung nach einem der Ansprüche 1 bis 8 und/oder durch eine Einrichtung nach einem der Ansprüche 9 bis 17.
